# FASCICULE DE BREVET EUROPEEN

(11) **EP 1 268 216 B1**
(45) Date de publication et mention de la délivrance du brevet: **15.08.2007**
(21) Numéro de dépôt: 00993700.4
(22) Date de dépôt: 27.12.2000
(51) Int. Cl.: B41N 1/00, B41N 1/12, G03F 7/09, G03F 7/11

(54) **PLAQUE D'IMPRESSION PRESENTEE EN ROULEAU ET PROCEDE D'OBTENTION**
ROLLENFÖRMIGE DRUCKPLATTE UND VERFAHREN ZUR HERSTELLUNG
PRINTING PLATE IN THE FORM OF A ROLLER AND METHOD FOR OBTAINING SAME

(30) Priorité: 31.12.1999 FR 9916816
(43) Date de publication de la demande: 02.01.2003
(73) Titulaire: MacDermid Graphic Arts S.A., 68700 Cernay (FR)
(72) Inventeur: SCHANEN, Michel, F-68116 Guewenheim (FR)
(74) Mandataire: Berger, Helmut
(86) Numéro de dépôt international: PCT/FR2000/003698
(87) Numéro de publication internationale: WO 2001/049509

(56) Documents cités:
- EP-A- 0 057 593
- EP-A- 0 177 302
- EP-A- 0 267 807
- EP-A- 0 803 773
- EP-A- 0 905 564
- EP-A- 0 916 480
- EP-A- 0 940 720
- WO-A-96/40528
- DE-A- 3 825 782
- US-A- 4 582 777
- US-A- 4 631 246
- US-A- 5 879 854
- US-A- 5 906 909
- PATENT ABSTRACTS OF JAPAN vol. 1999, no. 03, 31 mars 1999 (1999-03-31) & JP 10 333328 A (HITACHI CHEM CO LTD), 18 décembre 1998 (1998-12-18)

## Description

L'invention concerne le domaine de l'impression et, plus particulièrement les plaques d'impression utilisées notamment pour l'impression flexographique ou typographique.

De telles plaques d'impression sont destinées à être positionnées sur un cylindre support d'une machine à imprimer. C'est par exemple le cas dans la plaque divulguée dans le brevet US5 906 909.

On connaît de nombreuses plaques d'impression qui comprennent une couche de photopolymère placée sur un support, qui est généralement un film de polyester. Par ailleurs, la couche de photopolymère est recouverte, sur son autre face, d'un film de protection.

Avant que la plaque d'impression ne soit utilisée, le film de protection est retiré et la couche de photopolymère est développée pour recevoir l'image à imprimer. Ce développement consiste à exposer, à la lumière UV, la couche de photopolymère à travers un masque, les zones non exposées de la couche de photopolymère étant ensuite éliminées avec un solvant. On obtient alors une couche avec des reliefs qui permettra de reproduire l'image.

Les plaques d'impression connues dans l'état de la technique sont livrées sous forme de feuilles d'un format donné.

Cette présentation en feuilles est rendue nécessaire par l'empilement de la couche de support rigide (au sens de non-étirable), de la couche de photopolymère et de la couche de protection également non-étirable, qui forme un complexe rigide à la flexion. Elle est également due au procédé d'obtention de ces plaques. En effet, celui-ci consiste à extruder la couche de photopolymère entre deux cylindres, ce qui génère immédiatement une couche rigide..

Cette présentation entraîne des pertes importantes, d'au moins 10 %, lorsque les imprimeurs découpent les plaques au format d'impression, avant leur montage sur le cylindre support d'une machine à imprimer.

Ces pertes grèvent le coût des plaques d'impression.

De surcroît, les plaques présentées en feuilles risquent d'être endommagées, notamment en surface, du fait de manipulations incorrectes lors de leur transport et de leur stockage.

Pour cette raison, les fabricants de plaques d'impression ont mis au point des emballages coûteux et encombrants, comprenant souvent des cartons de différentes épaisseurs ainsi que des mousses, pour protéger les plaques d'impression qu'ils contiennent. De plus, un emballage spécifique doit être conçu pour chaque format particulier de plaques d'impression, ce qui accroît encore l'espace nécessaire au stockage de ces emballages.

Enfin, avant d'être emballées ou utilisées, les plaques d'impression sont stockées sur des rayons différents, en fonction de leurs dimensions et de leur épaisseur. Ceci prend beaucoup d'espace au sol, dans la mesure où, en général, au moins vingt plaques d'épaisseur et de tailles différentes doivent être disponibles.

Il a été envisagé, comme dans le document de brevet EP0905564, de stocker la plaque sous forme de rouleau.

L'invention propose un procédé de fabrication d'une plaque présentée en rouleau telle que définie par la revendication 1, et un plaque présentée en rouleau telle que définie par la revendication 8. D'autres caractéristiques de l'invention sont données dans les revendications dépendantes.

L'invention sera mieux comprise, et d'autres buts, avantages et caractéristiques de celle-ci apparaîtront plus clairement à la lecture de la description qui suit et qui est faite au regard des dessins annexés sur lesquels :
- la figure 1 représente schématiquement une installation permettant la mise en oeuvre d'une première variante du procédé selon l'invention ;
- la figure 2 est une vue en coupe d'une plaque d'impression en rouleau, obtenue par le procédé décrit en référence à la figure 1 ;
- la figure 3 est une vue schématique d'une installation permettant la mise en oeuvre d'une deuxième variante du procédé selon l'invention ;
- la figure 4 est une vue en coupe d'une plaque d'impression présentée sous forme de rouleau, obtenue par le procédé décrit en référence à la figure 3 ;
- la figure 5 représente schématiquement une autre installation permettant la mise en oeuvre de la première variante du procédé selon l'invention et
- la figure 6 représente schématiquement une autre installation permettant la mise en oeuvre de la deuxième variante du procédé selon l'invention.

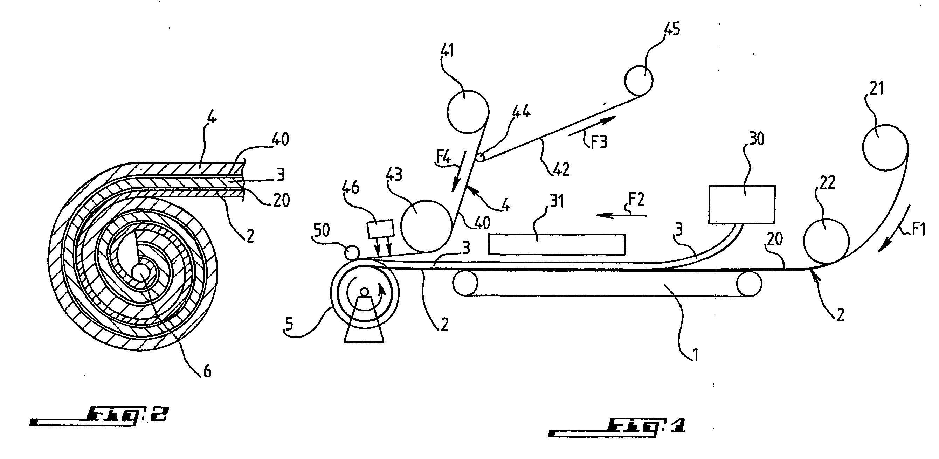

On se réfère tout d'abord à la figure 1, où la référence 1 désigne un convoyeur à bande ou moyen de supportage et de transport adapté, sur lequel est déposé un film de protection 2.

Ce film de protection est alimenté depuis un rouleau d'alimentation 21 et il est guidé jusqu'au convoyeur 1 par un deuxième rouleau 22. La circulation du film de protection est schématisée par la flèche F1.

Sur ce film de protection 2, est extrudée, par des moyens appropriés 30, une couche de photopolymère 3.

Bien sûr, le procédé selon l'invention n'est pas limité à ce mode de réalisation de la couche de photopolymère qui peut également être obtenue par d'autres moyens et notamment par enduction.

Le film de protection 2 et la couche de photopolymère 3 sont déplacés par le convoyeur 1, selon un mouvement de translation, schématisé par la flèche F2.

Le film de protection et la couche de photopolymère passent ensuite sous des moyens de chauffage 31, du type infrarouge, qui ont pour fonction de chauffer légèrement la couche de photopolymère de façon à la rendre plus collante.

Ces moyens 31 ne sont pas obligatoirement prévus, mais ils permettent de réactiver la surface extérieure de la couche de photopolymère, ce qui favorise sa fixation sur la couche de support 4 qui va maintenant être décrite.

Cette couche de support 4 provient d'un rouleau d'alimentation 41.

Sur le rouleau 41, la couche de support 4 est munie d'un film de silicone 42 qui est retiré de la couche support, guidé par le rouleau 44 et enroulé sur un support approprié 45. La circulation de la feuille de silicone 42 est schématisée par la flèche F3.

La couche de support 4 est, quant à elle, conduite jusqu'à la partie supérieure d'un enrouleur 5, par des moyens de guidage 43. Le déplacement de la feuille de support 4 est illustré par la flèche F4.

A la partie supérieure de l'enrouleur 5, la couche de support 4 vient en contact avec la couche de photopolymère 3 déposée sur le film de protection 2.

De préférence, la couche de support 4 comporte, sur sa face en regard de la couche de photopolymère, une couche 40 d'un matériau collant, sensible à la pression.

Ainsi, grâce à la pression exercée par le rouleau 50, prévu à la partie supérieure de l'enrouleur 5, la couche de support 4 est bien fixée sur la couche de photopolymère 3.

Cette fixation est favorisée par un léger chauffage de la couche de support 4, obtenu par exemple par des moyens de chauffage infrarouge 46.

Bien entendu, le procédé selon l'invention n'est pas limité à ce mode de mise en oeuvre et la fixation entre la couche de photopolymère et la couche de support pourrait être obtenue par d'autres moyens, comme des adhésifs UV spécialisés.

Au fur et à mesure de la constitution de l'ensemble formé par le film de protection 2, la couche de photopolymère 3 et la couche de support 4, cet ensemble est enroulé sur l'enrouleur 5.

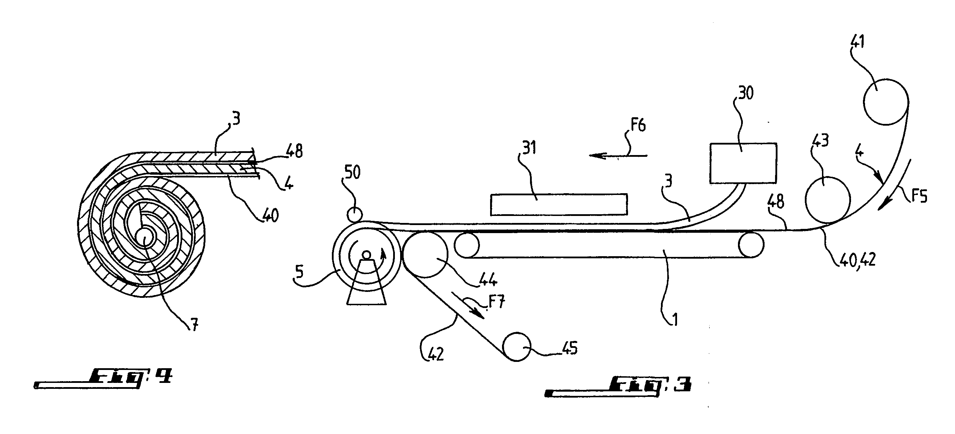

La plaque d'impression présentée en rouleau qui est ainsi obtenue sera décrite en référence à la figure 2.

On peut encore noter que le film de protection 2 peut comporter, sur sa face destinée à être en contact avec la couche de photopolymère 3, une couche 20 en matériau anti-adhérent, communément appelée "slip film".

Comme on l'a indiqué plus haut, le film de protection est retiré de la plaque d'impression, avant le développement de la couche de photopolymère.

Ce développement s'effectue généralement en positionnant un masque ou négatif sur la couche de photopolymère. Cette couche est légèrement collante. Il n'est donc pas toujours aisé de retirer le masque de la couche de photopolymère, après sa mise en place, par exemple pour le repositionner correctement.

C'est pourquoi cette couche de matériau anti-adhérent est généralement prévue sur le film de protection. Cette couche de matériau anti-adhérent reste fixée sur la couche de photopolymère, après le retrait du film de protection. Elle facilite ensuite le retrait du masque de la couche de photopolymère lorsque celui-ci se révèle utile.

Par ailleurs, dans le procédé qui vient d'être décrit, la première couche sur laquelle est formée la couche de photopolymère est le film de protection 2, tandis que la deuxième couche, fixée ultérieurement sur la couche de photopolymère, est la couche de support 4.

Bien entendu, l'invention n'est pas limitée à ce mode de mise en oeuvre et la couche de photopolymère 3 pourrait être formée sur la couche de support 4, le film de protection 2 étant alors appliqué sur la face de la couche de photopolymère opposée à la couche de support, lors de l'enroulement de l'ensemble.

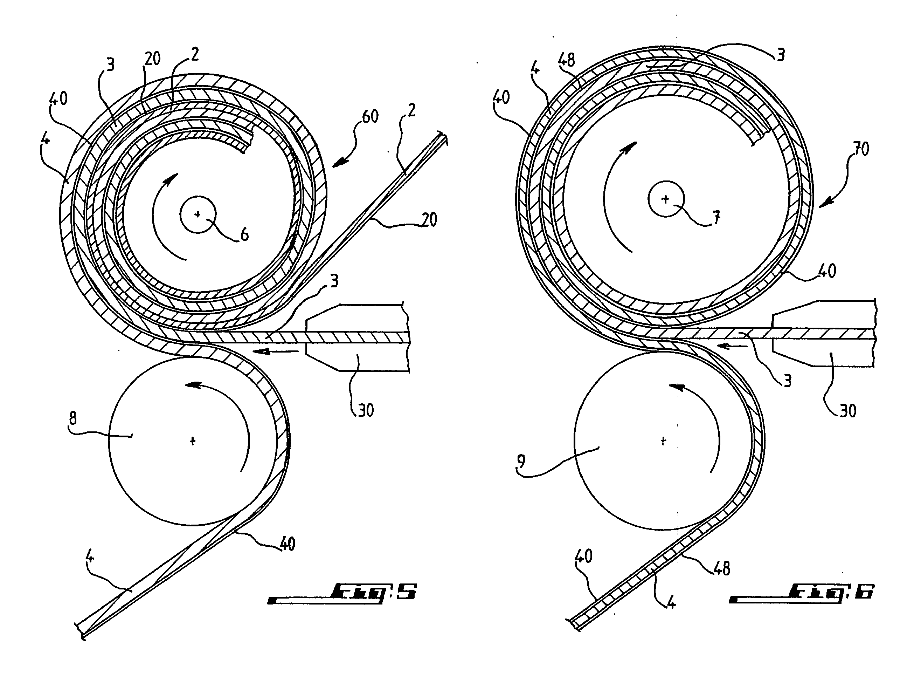

C'est ce mode de mise en oeuvre qui est illustré à la figure 5 qui représente une variante de l'installation illustrée à la figure 1.

Cette installation comporte un support 6 pour le rouleau 60 en formation et un cylindre 8 qui guide la couche de support 4 munie d'une couche 40 de matériau collant. Le support 6 et le cylindre 8 tournent en sens inverse.

Ainsi, la couche de photopolymère est extrudée par les moyens 30. Puis, sur la couche de photopolymère 3 sont amenés d'une part, du côté intérieur du rouleau 60, le film de protection 2 avec une couche 20 de matériau anti-adhérent et d'autre part, du côté extérieur du rouleau 60, la couche de support 4.

Les couches 2, 20, 3, 40 et 4 superposées passent entre le cylindre 8 et le rouleau 60 et viennent s'enrouler sur le rouleau en formation.

D'autres installations permettant d'obtenir une plaque en rouleau telle qu'illustrée à la figure 2 peuvent bien sûr être envisagées.

On se réfère maintenant à la figure 2 qui montre, en coupe transversale à l'axe, une plaque d'impression en rouleau selon l'invention obtenue par le procédé décrit en référence à la figure 1 ou à la figure 5.

Cette plaque d'impression est donc constituée des quatre couches suivantes, considérées successivement depuis le support 6 du rouleau, le film de protection 2, la couche de matériau anti-adhérent 20, la couche de photopolymère 3, la couche de matériau collant 40 et la couche de support 4. Le motif constitué par ces cinq couches se répète sur l'ensemble du rouleau selon un diamètre de celui-ci.

Bien entendu, l'enroulement des différentes couches pourrait être effectué en sens inverse, la couche 4 étant alors en contact avec le support 6.

Ainsi, dans la plaque d'impression obtenue, le film de protection 2 et la couche de support 4 sont en contact.

Comme on l'a expliqué précédemment, l'invention n'est pas limitée à une plaque d'impression comportant ces cinq couches. En particulier, la couche de matériau anti-adhérent et/ou la couche de matériau collant pourraient être omises. Par ailleurs, d'autres couches pourraient être déposées sur la couche de photopolymère, avant la fixation de la dernière couche, couche de support 4 ou film de protection 2. On peut notamment envisager de déposer une couche en matériau compressible sur la couche de photopolymère 3. Cette couche compressible pourrait également être déposée au préalable sur la couche de support 4 avant mise en contact de cette couche de support 4 munie de cette couche compressible, sur la couche de photopolymère 3.

On peut également envisager d'autres couches telles que des couches digitales ou des couches de contraste qui améliorent le transfert d'encre ou des combinaisons pertinentes de ces couches.

Par ailleurs, de façon classique, le film de protection est un film de polyester, tandis que la couche en matériau anti-adhérent est classiquement réalisée en polyamide ou en cellulose.

Le revêtement collant 40 de la couche 4 peut notamment être réalisé en un adhésif sensible à la pression ou un adhésif spécialisé sensible aux UV, tandis que la couche de support 4 est, par exemple, réalisée en polyester.

On se réfère maintenant à la figure 3 qui représente une installation permettant la mise en oeuvre d'une deuxième variante du procédé selon l'invention.

Sur le convoyeur à bande 1, est déposée une couche de support 4.

Cette couche de support est alimentée depuis un rouleau d'alimentation 41 et elle est guidée jusqu'au convoyeur 1 par un deuxième rouleau 43. La circulation de la couche de support est schématisée par la flèche F5.

Dans l'exemple représenté, la couche de support 4 comporte, sur sa face destinée à être en contact avec le convoyeur 1, et successivement, une couche 40 de matériau collant, sensible à la pression, en contact avec la couche support elle-même, et d'une feuille de protection 42, en silicone, déposée sur cette couche de matériau collant.

Sur cette couche de support 4, du côté opposé aux couches 40 et 42, est extrudée, par des moyens appropriés 30, une couche de photopolymère 3.

Comme indiqué précédemment, le procédé selon l'invention n'est pas limité à ce mode de réalisation de la couche de photopolymère, laquelle pourrait être obtenue par tout autre moyen et notamment par enduction.

De façon préférée, la couche de support 4 comporte, sur sa face opposée aux couches 40 et 42, une couche de matériau anti-adhérent 48.

Après le dépôt de la couche de photopolymère 3, la couche de support 4 et cette couche 3 sont déplacées par le convoyeur 1, selon un mouvement de translation, schématisé par la flèche F6.

La couche de support 4 et la couche de photopolymère 3 passent ensuite sous des moyens de chauffage 31, du type infrarouge, qui ont toujours pour fonction de chauffer légèrement la couche de photopolymère de façon à la rendre plus collante.

Comme indiqué précédemment en référence à la figure 1, ces moyens de chauffage ne sont pas obligatoirement prévus, mais ils permettent de réactiver la surface extérieure de la couche de photopolymère. Ceci favorise sa fixation sur la couche de support 4 qui se produit lors de l'enroulement, comme cela va maintenant être décrit.

Avant que la couche de support et la couche de photopolymère n'arrivent sur l'enrouleur 5, le film de silicone 42 est retiré de la couche de support 4. Il est guidé par le rouleau 44 et enroulé sur un support approprié 45. La circulation de la feuille de silicone 42 est schématisée par la flèche F7.

Ainsi, c'est l'ensemble constitué par la couche de photopolymère 3 et la couche de support 4, avec sa couche 40 de matériau collant en surface, qui arrive à la partie supérieure de l'enrouleur 5.

Après que cet ensemble a été enroulé sur un tour complet, sur l'enrouleur 5, la couche de revêtement collant 40 de la couche de support vient en contact sur la couche de photopolymère 3 précédemment enroulée.

Grâce à la pression exercée par le rouleau 50, prévu à la partie supérieure de l'enrouleur 5, la couche de support 4 est bien fixée sur la couche de photopolymère 3, notamment lorsque le matériau collant de la couche 40 est sensible à la pression.

On se réfère maintenant à la figure 4 qui montre, en coupe transversale à l'axe, une plaque d'impression en rouleau selon l'invention, obtenue par le procédé décrit en référence à la figure 3.

Cette plaque d'impression est donc constituée des quatre couches suivantes, considérée successivement depuis le support 7 du rouleau, la couche de matériau collant 40, la couche de support 4, la couche de matériau anti-adhérent 48 et la couche de photopolymère 3. Ce motif se répète sur l'ensemble du rouleau, selon un diamètre de celui-ci.

Ainsi, dans la plaque d'impression obtenue, la couche de photopolymère 3 est fixée sur la couche de support 4 enroulée directement sur elle, ici par l'intermédiaire de la couche 40 en matériau collant.

Ainsi, dans cette plaque d'impression, la couche de support 4 joue également le rôle d'un film de protection de la couche de photopolymère 3.

Cette plaque d'impression ainsi que le procédé d'obtention correspondant présentent donc l'avantage d'éliminer une des deux couches classiquement prévues de part et d'autre de la couche de photopolymère. Ceci diminue nécessairement le coût de réalisation de la plaque d'impression et facilite son enroulement.

On se réfère maintenant à la figure 6 qui illustre une variante de l'installation illustrée à la figure 3.

Cette installation comporte un support 7 pour le rouleau 70 en formation et un cylindre 9 qui guide la couche de support 4, munie d'un côté d'une couche de matériau anti-adhérent 48 et de l'autre côté d'une couche de matériau collant 40.

Le support 7 et le cylindre 9 tournent en sens inverse.

La couche de photopolymère 3 est extrudée par les moyens 30.

La couche de support 4 lui est appliquée sur sa face située vers l'extérieur du rouleau 70, la couche 48 étant directement en contact avec la couche 3.

Les couches 40, 4, 48 et 3 superposées passent entre le rouleau 70 et le cylindre 9 formant une calandre et viennent s'enrouler sur le rouleau en formation.

La couche de photopolymère 3 est alors fixée sur la couche de support 4 enroulée juste avant elle, ici par la couche 40.

Le rouleau 70 obtenu comporte les mêmes couches que le rouleau illustré à la figure 4, mais dans un ordre inverse par rapport au support 7. Les quatre couches sont, en effet, disposées selon le motif suivant, depuis le support 7 du rouleau : la couche de photopolymère 3, la couche de matériau anti-adhérent 48, la couche de support 4 et la couche de matériau collant 40.

Comme cela a été indiqué précédemment, l'invention n'est pas limitée à cette plaque d'impression comportant quatre couches successives. En particulier, la couche de matériau anti-adhérent et/ou la couche de matériau collant pourrait être omise. Par ailleurs, d'autres couches pourraient être déposées sur la couche de photopolymère, avant son enroulement sur l'enrouleur 5.

Dans tous les cas, l'invention permet d'obtenir une plaque d'impression en rouleau, contrairement aux procédés classiques.

Cette présentation en rouleau permet de limiter les pertes, lors de la découpe des plaques d'impression. En effet, l'utilisateur peut découper la plaque à la longueur désirée, ce qui entraîne une économie de matière d'au moins 10 %.

De plus, la plaque d'impression selon l'invention est stockée d'une manière plus compacte. Ceci réduit considérablement l'espace nécessaire chez l'utilisateur pour stocker les plaques d'impression avant leur développement et réduit également considérablement le coût des emballages pour le transport de ces plaques d'impression en rouleau, et donc le coût du transport lui-même.

La réduction du volume et du poids de l'emballage nécessaire au conditionnement de ces plaques permet également de réduire la quantité de déchets à éliminer.

Par ailleurs, grâce à cette présentation en rouleau, la plaque est naturellement protégée de rayures accidentelles.

Enfin, dans la deuxième variante illustrée à la figure 4, la plaque d'impression ne comporte qu'une couche de support qui remplit également une fonction de film de protection, ce qui réduit encore le coût de la plaque.

Les signes de référence insérés après les caractéristiques techniques figurant dans les revendications ont pour seul but d'améliorer la compréhension de ces dernières et ne sauraient en limiter la portée.

## Revendications

1. Procédé de fabrication d'une plaque d'impression présentée en rouleau et comprenant une couche de photopolymère collée à une couche support, **caractérisé en ce que** l'on :
- fait parvenir séparément la couche de photopolymère (3) et la couche support (4) pourvue sur une face d'un revêtement de matériau collant (40) sensible à la pression, à un enrouleur (5) de ces couches;
- fixe la couche photosensible (3) à la couche de support (4) au moyen de la couche (40) collante sensible à la pression lors de l'enroulement.

2. Procédé selon la revendication 1, dans lequel on utilise un rouleau (50) situé à l'entrée de l'enrouleur (5) pour exercer une pression radiale par rapport à l'enroulement favorisant la fixation.

3. Procédé selon la revendication 1 ou 2, dans lequel à l'entrée de l'enrouleur (5), la couche de photopolymère (3) est appliquée sur la face de la couche support (4) opposée à la couche (40) collante et sensible à la pression.

4. Procédé selon l'une des revendications 1 à 3, dans lequel on dépose, sur la couche de photopolymère (3), au moins une autre couche et notamment une couche compressible, avant de procéder à l'enroulement.

5. Procédé selon l'une des revendications 1 à 4, dans lequel on utilise une couche support (4) comportant, sur sa face opposée à la couche (40) collante et sensible à la pression, une couche de matériau anti-adhérent (48).

6. Procédé selon l'une des revendications 1 à 5, dans lequel une feuille de protection est déposée sur le revêtement (40) de matériau collant sensible à la pression et est retirée avant l'entrée de la couche de support dans l'enrouleur (5).

7. Procédé selon l'une des revendications 1 à 6, **caractérisé en ce que** la couche de photopolymère (3) est obtenue par extrusion, puis laminée.

8. Plaque d'impression conditionnée en rouleau comprenant successivement une couche de photopolymère (3) et une couche de support et de protection (4), **caractérisé en ce que** dans ledit rouleau, la couche de photopolymère (3) est en contact sur ses deux faces avec la couche de support et de protection (4) et **en ce qu'**une couche (40) d'un matériau collant et sensible à la pression est prévue sur la couche de support et de protection (4), par laquelle la couche de photopolymère (3) est fixée sur la couche de support et de protection (4), lesdites couches se succédant dans le rouleau, selon le motif suivant : couche de matériau collant (40), couche de support (4) et couche de photopolymère (3).

9. Plaque d'impression selon la revendication 8, comprenant une couche de matériau anti-adhérent (48) entre la couche de support (4) et la couche de photopolymère (3), les différentes couches se succédant, selon le motif suivant: couche (40) de matériau collant le cas échéant, couche de support (4), couche de matériau anti-adhérent (48) et couche de photopolymère (3).

10. Procédé selon la revendication 1, dans lequel on applique la couche photopolymère (3) sur un film de protection (2), et on enroule la couche support (4), la couche de photopolymère (3) avec son film de protection (2), de manière à fixer la couche support (4) à la face de la couche photopolymère (3) opposée au film de protection (2) pendant l'enroulement.

11. Procédé selon la revendication 1, dans lequel on applique un film de protection (2) à la face de la couche photopolymère (3) opposée à la couche support (4) en enroulant la couche support (4), la couche photopolymère (3) avec son film de protection (2) de telle sorte que le film de protection (2) et la couche support (4) soient en contact dans le rouleau.

12. Procédé selon l'une des revendications 10 à 11, **caractérisé en ce que** le film de protection est en polyester.

## Claims

1. Method for obtaining a printing plate in the form of a roller comprising a photopolymer layer stuck to a support layer, **characterised in that**:
- the photopolymer layer (3) and the support layer (4), provided with a covering of pressure sensitive adhesive material (40) on one face, are fed separately to a winder (5) for these layers;
- the photosensitive layer (3) is fixed to the support layer (4) by means of the pressure sensitive adhesive layer (40), during winding.

2. Method according to claim 1, in which a roller (50) situated at the entry to the winder (5) is used to exert a radial pressure in relation to winding which encourages fixing.

3. Method according to claim 1 or 2, in which the photopolymer layer (3) is applied to the face of the support layer (4) opposite the pressure sensitive adhesive layer (40), at the entry to the winder (5).

4. Method according to one of claims 1 to 3, in which at least one other layer is put on the photopolymer layer (3), particularly a compressible layer, before proceeding with winding.

5. Method according to one of claims 1 to 4, in which a support layer (4) is used, comprising a layer of non-stick material (48) on the face opposite the pressure sensitive adhesive layer (40).

6. Method according to one of claims 1 to 5, in which a protective sheet is put on the covering (40) of pressure sensitive adhesive material, and is removed before the support layer enters the winder (5).

7. Method according to one of claims 1 to 6, **characterised in that** the photopolymer layer (3) is obtained by extrusion, then laminated.

8. Printing plate packed in a roller, comprising a photopolymer layer (3) and a support and protective layer (4) in succession, **characterised in that** in this roller the photopolymer layer (3) is in contact on both faces with the support and protective layer (4) and that a layer (40) of pressure sensitive adhesive material, is provided on the support and protective layer (4), by which the photopolymer layer (3) is fixed on the support and protective layer (4), these layers succeeding each other in the winder according to the following pattern: layer of adhesive material (40), support layer (4) and photopolymer layer (3).

9. Printing plate according to claim 8, comprising a layer of non-stick material (48) between the support layer (4) and the photopolymer layer (3), the different layers succeeding each other according to the following pattern: layer (40) of adhesive material, if necessary, support layer (4), layer of non-stick material (48) and photopolymer layer (3).

10. Method according to claim 1, in which the photopolymer layer (3) is applied on a protective film (2) and the support layer (4) and photopolymer layer (3) with its protective film (2) are wound so as to fix the support layer (4) to the face of the photopolymer layer (3) opposite the protective film (3) during winding.

11. Method according to claim 1, in which a protective film (2) is applied to the face of the photopolymer layer (3) opposite the support layer (4) by winding the support layer (4) and the photopolymer layer (3) with its protective film (2) in such a way that the protective film (2) and the support layer (4) are in contact in the roller.

12. Method according to one of claims 10 to 11, **characterised in that** the protective film is made of polyester.

## Patentansprüche

1. Verfahren zur Herstellung einer Druckplatte, die in Rollenform dargestellt ist und eine Photopolymerschicht umfasst, die an eine Trägerschicht angehaftet ist, **dadurch gekennzeichnet, dass**:
- die Photopolymerschicht (3) und die Trägerschicht (4), die auf einer Oberfläche mit einer Beschichtung aus druckempfindlichem Haftmaterial (40) versehen ist, getrennt auf einer Laufrolle (5) dieser Schichten angebracht werden können;
- die photoempfindliche Schicht (3) mittels der druckempfindlichen Haftschicht (40) bei der Aufwicklung an der Trägerschicht (4) befestigt wird.

2. Verfahren nach Anspruch 1, bei dem eine Rolle (50) verwendet wird, die sich am Einlass der Laufrolle (5) befindet, um einen radialen Druck in Bezug auf die Aufwicklung auszuüben und somit die Fixierung zu begünstigen.

3. Verfahren nach Anspruch 1 oder 2, bei dem am Einlass der Laufrolle (5) die Photopolymerschicht (3) auf der Oberfläche der Trägerschicht (4) gegenüber der druckempfindlichen Haftschicht (40) aufgebracht wird.

4. Verfahren nach einem der Ansprüche 1 bis 3, bei dem auf der Photopolymerschicht (3) mindestens eine weitere Schicht und insbesondere eine komprimierbare Schicht aufgebracht wird, bevor die Aufwicklung vorgenommen wird.

5. Verfahren nach einem der Ansprüche 1 bis 4, bei dem eine Trägerschicht (4) verwendet wird, die auf ihrer Oberfläche gegenüber der druckempfindlichen Haftschicht (40) eine Schicht aus nicht haftendem Material (48) umfasst.

6. Verfahren nach einem der Ansprüche 1 bis 5, bei dem eine Schutzfolie auf der Beschichtung (40) aus druckempfindlichem Haftmaterial aufgebracht ist und vor dem Einlass der Trägerschicht in die Laufrolle (5) zurückgezogen wird.

7. Verfahren nach einem der Ansprüche 1 bis 6, **dadurch gekennzeichnet, dass** die Photopolymerschicht (3) durch Extrudieren und anschließendes Laminieren erhalten wird.

8. Druckplatte in Rollenform, die nacheinander eine Photopolymerschicht (3) und eine Träger- und Schutzschicht (4) umfasst, **dadurch gekennzeichnet, dass** die Photopolymerschicht (3) in der Rolle über ihre beiden Oberflächen mit der Träger- und Schutzschicht (4) in Kontakt steht und **dadurch**, dass eine aus einem druckempfindlichen Haftmaterial bestehende Schicht (40) auf der Träger- und Schutzschicht (4) vorgesehen ist, durch die die Photopolymerschicht (3) auf der Träger- und Schutzschicht (4) fixiert ist, wobei die Schichten in der Rolle nach folgendem Muster aufeinander folgen: Schicht aus Haftmaterial (40), Trägerschicht (4) und Photopolymerschicht (3).

9. Druckplatte nach Anspruch 8, die eine Schicht aus nicht haftendem Material (48) zwischen der Trägerschicht (4) und der Photopolymerschicht (3) umfasst, wobei die Schichten nach folgendem Muster aufeinander folgen: Schicht aus Haftmaterial (40), gegebenenfalls Trägerschicht (4), Schicht aus nicht haftendem Material (48) und Photopolymerschicht (3).

10. Verfahren nach Anspruch 1, bei dem die Photopolymerschicht (3) auf einen Schutzfilm (2) aufgebracht wird und die Trägerschicht (4), die Photopolymerschicht (3) mit ihrem Schutzfilm (2) derart aufgewickelt werden, dass die Trägerschicht (4) während der Aufwicklung auf der Oberfläche der Photopolymerschicht (3) gegenüber dem Schutzfilm (2) befestigt wird.

11. Verfahren nach Anspruch 1, bei dem ein Schutzfilm (2) auf der Oberfläche der Photopolymerschicht (3) gegenüber der Trägerschicht (4) aufgebracht wird, indem die Trägerschicht (4), die Photopolymerschicht (3) mit ihrem Schutzfilm (2) derart aufgewickelt werden, dass der Schutzfilm (2) und die Trägerschicht (4) in der Rolle in Kontakt stehen.

12. Verfahren nach einem der Ansprüche 10 bis 11, **dadurch gekennzeichnet, dass** der Schutzfilm aus Polyester besteht.
